# EUROPÄISCHE PATENTSCHRIFT

(11) **EP 1 864 378 B1**
(45) Veröffentlichungstag und Bekanntmachung des Hinweises auf die Patenterteilung: **30.12.2015**
(21) Anmeldenummer: 06723832.9
(22) Anmeldetag: 29.03.2006
(51) Int. Cl.: H03G 3/30

(54) **LEISTUNGSREGELVORRICHTUNG**
POWER CONTROL DEVICE
DISPOSITIF DE REGULATION DE PUISSANCE

(30) Priorität: 01.04.2005 DE 102005015092; 12.01.2006 DE 102006001687
(43) Veröffentlichungstag der Anmeldung: 12.12.2007
(73) Patentinhaber: Rohde & Schwarz GmbH & Co. KG, 81671 München (DE)
(72) Erfinder: TRÄGER, Robert, 85521 Riemerling (DE); KREUSSER, Stefan, 82140 Olching (DE)
(74) Vertreter: Körfer, Thomas
(86) Internationale Anmeldenummer: PCT/EP2006/002863
(87) Internationale Veröffentlichungsnummer: WO 2006/103059

(56) Entgegenhaltungen:
- DE-A1- 2 710 752
- DE-A1- 3 918 159
- US-A- 4 729 129

## Beschreibung

Die Erfindung betrifft eine Leistungsregelvorrichtung für Leistungsendstufen.

Zum Schutz der Leistungsverstärker, insbesondere der Hochfrequenz-Leistungstransistoren, vor einer Überlastung durch von der Antenne reflektierter Leistung bei schlechter Anpassung der Antenne ist es üblich, mittels eines Richtkopplers die auf der Antennenzuleitung vorlaufenden und rücklaufenden Wellen zu überwachen und ggf. den Eingangspegel der Endstufen über einen Regelkreis zu reduzieren. Um bei räumlich dicht benachbarten Sendern, z.B. auf Schiffen, die im gleichen Frequenzbereich mit z.T. nur geringfügigem Frequenzabstand betrieben werden, eine ungewollte Sendeleistungsreduzierung zu vermeiden, werden in die Antennenzuleitung häufig schmalbandige Sendefilter eingefügt. Diese haben jedoch den Nachteil, daß sie aufgrund ihrer Schmalbandigkeit äußerst aufwendig und dementsprechend teuer sind und einer extremen Beanspruchung der Hochfrequenz-Schaltelemente ausgesetzt sind.

Aus der DE 39 18 159 A1 ist es zur Vermeidung dieser schmalbandigen Sendefilter bereits bekannt, den Regelkreis frequenzselektiv zu betreiben. Dazu wird das von dem Richtkoppler gewonnene Vorlaufsignal und Rücklaufsignal jeweils einer I/Q-Demodulation unterworfen, wobei für die Mischer des I/Q-Demodulators ein Referenzsignal verwendet wird, das aus dem HF-Signalzweig vor der zu regelnden Leistungsendstufe ausgekoppelt wird. Die Frequenzselektivität ist dabei von der Flankensteilheit der den Mischern nachgeschalteten Tiefpässe in dem Inphase(I)-Zweig und dem Quadraturphase(Q)-Zweig des Basisbandes abhängig. An die Tiefpässe, von welchen insgesamt vier Stück (jeweils eines für den I-Zweig und Q-Zweig des Vorlaufsignals und des Rücklaufsignals) benötigt werden, sind daher relativ hohe Anforderungen zu stellen, die in der Regel nur durch schaltungstechnisch relativ aufwendige aktive Filter erfüllt werden können. Außerdem muß das Regelsignal mittels insgesamt vier Quadrierer, zwei Summierer und zwei Radizierglieder aufwendig erzeugt werden. Auch wenn alternativ vorgeschlagen wird, diese Prozedur mittels einer im Multiplexbetrieb arbeitenden digitalen Signalverarbeitung zu realisieren, ist der Aufwand auch bei dieser digitalen Realisierung noch immer beträchtlich.

Der Erfindung liegt daher die Aufgabe zugrunde, eine Leistungsregelanordnung für Leistungsendstufen zu schaffen, deren Aufwand deutlich verringert ist.

Die Aufgabe wird durch eine Leistungsregelanordnung mit den Merkmalen des Anspruchs 1 gelöst. Die Unteransprüche enthalten vorteilhafte Weiterbildungen der Erfindung.

Erfindungsgemäß wird vorgeschlagen, die schmalbandige Selektion nicht im Basisband, sondern auf einer Zwischenfrequenzebene oberhalb des Basisbandes durchzuführen.

Die Mischer in dem Vorlaufsignalzweig und dem Rücklaufsignalzweig mischen daher nicht in die Null-Frequenzlage des Basisbandes, sondern in eine Zwischenfrequenzlage. Die Zwischenfrequenzlage ist bezüglich der Hochfrequenzlage nicht abgesenkt sondern sogar noch angehoben. In dieser Zwischenfrequenzlage werden dann sehr schmalbandige Filter, bevorzugt Oberflächenwellen-Filter, zur Frequenzselektion eingesetzt. Diese Zwischenfrequenzfilter sind wesentlich einfacher ausgebildet, als die beim Stand der Technik verwendeten Tiefpaßfilter im Basisband. Außerdem lassen sich mit Oberflächenwellen-Filtern wesentlich größere Flankensteilheiten realisieren, als mit Tiefpaßfiltern im Basisband. Somit lassen sich die Kosten und auch der Bauraum für die Realisierung gegenüber der aus dem Stand der Technik bekannten Lösung erheblich reduzieren.

Bei einer vorzugsweisen Ausgestaltung wird auf ein Referenzsignal verzichtet, welches aus dem HochfrequenzSignalzweig vor der zu regelnden Leistungsendstufe ausgekoppelt wird, sondern es wird ein eigens erzeugtes Referenzsignal benutzt.

Es ist vorteilhaft, das Referenzsignal für die Mischer in den selektiven Signalzweigen einem speziellen Synthesizer zu entnehmen, der auch die Signalaufbereitung in dem der Leistungsendstufe vorgeschalteten Steuersender versorgt. Somit ist ein Signalabgriff des Referenzsignals unmittelbar vor der Leistungsendstufe, wie er beim Stand der Technik vorgesehen ist, nicht notwendig und der ohnehin vorhandene Synthesizer kann für die Gewinnung des Referenzsignals genutzt werden.

Das Referenzsignal wird dabei nicht aus dem Synthesizer entnommen, der im eigentlichen Transceiver genutzt wird, sondern wird in der Erfindung unmittelbar erzeugt. Dies ist ein wesentlicher Vorteil, da z. B. bei Signalen mit unterdrücktem Träger eine Erzeugung des Referenzsignals aus dem eigentlichen Hochfrequenz-Signalzweig sehr kompliziert ist, und in Sendepausen des eigentlichen Senders, während denen allerdings Störsignale benachbarter Sender vorliegen, kein Referenzsignal vorliegt.

Des weiteren ist es vorteilhaft, neben dem selektiven Vorlaufsignalzweig und dem selektiven Rücklaufsignalzweig einen breitbandigen Vorlaufsignalzweig und einen breitbandigen Rücklaufsignalzweig vorzusehen, deren Bandbreite sich über die gesamte Nutzbandbreite der Leistungsendstufe erstreckt und nicht selektiv auf das momentane Sendesignal eingeschränkt ist. Der breitbandige Vorlaufsignalzweig kann dann für eine Notabschaltung verwendet werden, indem das breitbandige Vorlaufsignal mit dem selektiven Vorlaufsignal in einem entsprechenden Komparator verglichen wird. Liegt in dem breitbandigen Signalzweig ein Vorlaufsignal mit hohem Pegel vor, ist der Pegel des selektiven Vorlaufsignals jedoch gering, so deutet dies auf einen Fehler in der Signalaufbereitung des selektiven Vorlaufsignalzweiges hin. Wäre der breitbandige Vorlauf signalzweig nicht vorhanden, so würde in diesem Fall der Regler trotz möglicherweise vorhandenem relativ hohen Rücklaufsignalpegel maximal aufregeln, da der Regler aufgrund des Fehlers in dem selektiven Vorlaufsignalzweig irrtümlich von einem geringen Vorlauf ausgehen würde. Wird jedoch gleichzeitig das breitbandige Vorlaufsignal erfaßt, so kann ab einem gewissen Schwellwert ggf. mit einer Zeitverzögerung eine Notabschaltung herbeigeführt werden.

Der breitbandige Rücklaufsignalzweig kann dazu dienen, daß eine Rückregelung der Sendeleistung der Leistungsendstufe herbeigeführt wird, wenn außerhalb des auf die momentane Betriebsfrequenz eingestellten selektiven Rücklaufs ein hoher Rücklauf bedingt durch benachbarte Sender auftritt. Strahlen benachbarte Sender nur mit niedrigem Pegel ein, so soll eine Rückregelung erfindungsgemäß zwar gerade vermieden werden. Strahlen diese Sender jedoch mit so hohem Pegel ein, daß die Gefahr der Zerstörung der Leistungsendstufe besteht, so soll die Leistung der Leistungsendstufe entsprechend zurückgeregelt werden. Dies wird dadurch realisiert, daß das breitbandige Rücklaufsignal ab einem gewissen Pegel das selektive Rücklaufsignal übersteuert und dominiert, während unterhalb dieses Schwellwerts nahezu ausschließlich das selektive Rücklaufsignal dominiert.

Ein Ausführungsbeispiel der Erfindung wird nachfolgend unter Bezugnahme auf die Zeichnung näher erläutert. In der Zeichnung zeigen:
- Fig. 1: ein Blockschaltbild eines Ausführungsbeispiels der erfindungsgemäßen Leistungsregelvorrichtung und
- Fig. 2: einen Anwendungsfall der erfindungsgemäßen Leistungsregelvorrichtung bei einer Breitbandanlage.

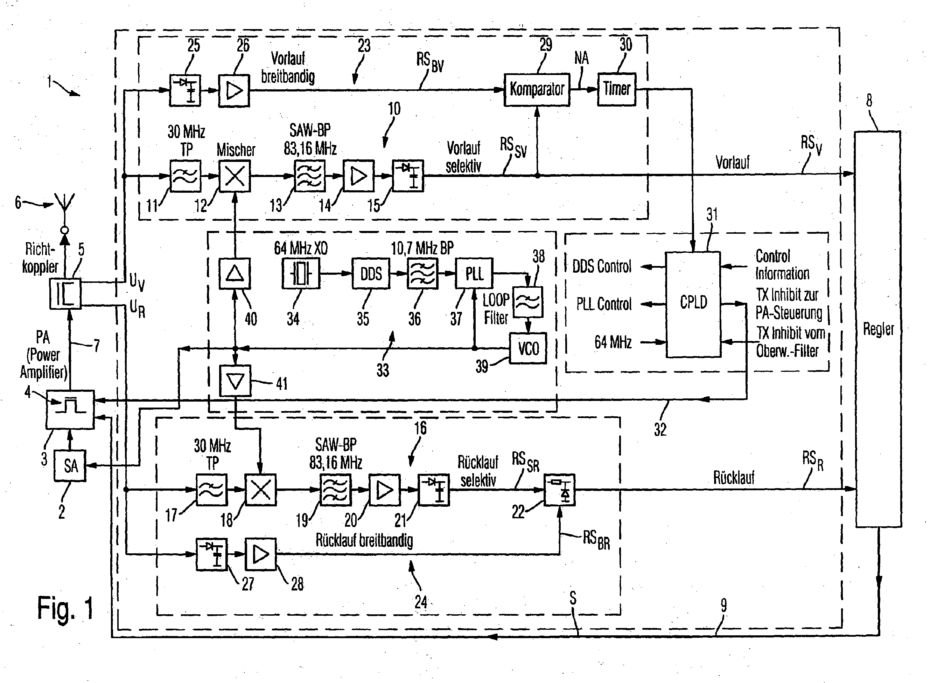

Fig. 1 zeit ein Ausführungsbeispiel der erfindungsgemäßen Leistungsregelvorrichtung, die allgemein mit dem Bezugszeichen 1 bezeichnet ist. Bei der Sendeeinrichtung erfolgt die Signalaufbereitung (u.a. Modulation, Filterung und Hochmischen auf die Betriebsfrequenz) in einer nicht näher dargestellten Signalaufbereitungseinrichtung 2. Das Sendesignal wird in der Hochfrequenzlage einem Leistungsverstärker 3 zugeführt, welcher eine Leistungsendstufe 4 in der Regel mit Hochfrequenz-Leistungstransistoren beinhaltet. Über eine Wellenzuleitung 7 und einen Richtkoppler 5 wird das Sendesignal einer Antenne 6 zugeführt.

Bei schlechter Anpassung der Antenne 6 wird ein Teil der Sendeleistung in die Leistungsendstufe 4 des Leistungsverstärkers 3 zurückreflektiert und dort absorbiert. Dies kann zu einer Überhitzung und im Extremfall zu einer Zerstörung der Hochfrequenz-Leistungstransistoren führen. Deshalb ist eine Regelvorrichtung vorzusehen, die das Verhältnis zwischen der auf der Zuleitung 7 zur Antenne vorlaufenden Welle und der von der Antenne 6 reflektierten und auf der Zuleitung 7 rücklaufenden Welle erfaßt und hieraus das Stehwellenverhältnis (VSWR = Voltage Standing Wave Ratio) berechnet. Mit zunehmendem Stehwellenverhältnis muß die Leistung der Leistungsendstufe 4 des Leistungsverstärkers 3 zurückgeregelt werden. Hierzu werden an dem Richtkoppler 5 ein Vorlaufsignal U_{V}, das dem Pegel einer auf der Zuleitung 7 vorlaufenden Welle entspricht, und ein Rücklaufsignal U_{R} erzeugt, das dem Pegel der auf der Zuleitung 7 rücklaufenden Welle entspricht. Aus dem Vorlaufsignal U_{V} wird ein Vorlauf-Regelsignal RS_{V} und aus dem Rücklaufsignal U_{R} wird ein Rücklauf-Regelsignal RS_{R} bestimmt, die einem Regler 8 zugeführt werden, der hieraus das Stehwellenverhältnis ermittelt und in Abhängigkeit davon ein Stellsignal S erzeugt, das über eine Leitung 9 dem Leistungsverstärker 3 zur Regelung der Leistung der Leistungsendstufe 4 zugeführt wird.

Im folgenden wird darauf eingegangen, wie das VorlaufRegelsignal RS_{V} und das Rücklauf-Regelsignal RS_{R} erfindungsgemäß erzeugt werden.

Hierzu wird das Vorlaufsignal U_{V} einem selektiven Vorlaufsignalzweig 10 zugeführt, der im dargestellten Ausführungsbeispiel aus einem ersten Tiefpaß 11, einem ersten Mischer 12, einem ersten Zwischenfrequenzfilter 13, einem ersten Verstärker 14 und einem ersten Gleichrichter 15 besteht. Entsprechend wird das Rücklaufsignal U_{R} einem selektiven Rücklaufsignalzweig 16 zugeführt, der im dargestellten Ausführungsbeispiel aus einem zweiten Tiefpaß 17, einem zweiten Mischer 18, einem zweiten Zwischenfrequenzfilter 19, einem zweiten Verstärker 20 und einem zweiten Gleichrichter 21 besteht.

Die optionalen Tiefpässe 11 und 17 sind so ausgelegt, daß ihre Grenzfrequenz der höchsten Betriebsfrequenz der Sendeeinrichtung entspricht, bzw. etwas oberhalb dieser höchsten Betriebsfrequenz liegt. Ist beispielsweise die Sendeeinrichtung für einen Kurzwellenbetrieb bis maximal 30 MHz ausgelegt, so entspricht die Grenzfrequenz der Tiefpaßfilter 11 und 17, wie in Fig. 1 dargestellt, dieser höchsten Betriebsfrequenz von 30 MHz.

Die Mischer 12 und 18 setzen das tiefpaßgefilterte Vorlaufsignal U_{V} bzw. das tiefpaßgefilterte Rücklaufsignal U_{R} auf eine von der Betriebsfrequenz der Sendeeinrichtung unabhängige Zwischenfrequenzebene um, im dargestellten Ausführungsbeispiel beispielsweise auf eine Zwischenfrequenz von 83,16 MHz. Auf dieser festen Zwischenfrequenz befindet sich die Durchlaßfrequenz des als Bandpaßfilter ausgelegten Zwischenfrequenzfilters 13 bzw. 19. Die Zwischenfrequenzfilter 13 und 19 sind vorzugsweise als Oberflächenwellen-Filter ausgebildet, da sich mit Oberflächenwellen-Filtern hohe Flankensteilheiten im Frequenzgang erzielen lassen.

Im dargestellten Ausführungsbeispiel wird durch die Mischer 12 und 18 das Signal nach oben auf eine Zwischenfrequenz gemischt, die oberhalb der höchsten Betriebsfrequenz der Sendeeinrichtung liegt. Dies ist bevorzugt, da somit eine Einstrahlung der Zwischenfrequenz in den Nutzfrequenzbereich sicher vermieden wird. Dies ist aber keineswegs zwingend. Bei einer genügenden Abschirmung der selektiven Signalzweige 10 und 16 kann die Zwischenfrequenz auch im Nutzbereich der Sendeeinrichtung liegen.

Hervorzuheben ist jedoch, daß die Filterung auf einer konstanten Zwischenfrequenzebene und nicht, wie beim Stand der Technik, im Basisband erfolgt. Wie bereits eingangs beschrieben, kann dadurch eine wesentlich bessere Filterung und somit eine wesentlich bessere Selektivität erzielt werden als bei der aus dem Stand der Technik bekannten Tiefpaßfilterung der I- und Q-Komponente im Basisband. Die Oberflächenwellen-Filter benötigen nur einen geringen Bauraum und bedingen nur geringe Fertigungskosten.

In den optionalen Vorverstärkern 14 und 20 findet eine Vorverstärkung des gefilterten Zwischenfrequenz-Signals statt, bevor das Signal jeweils einem Gleichrichter 15 bzw. 21 zugeführt wird, welcher das Signal gleichrichtet und anschließend tiefpaßfiltert. Am Ausgang des selektiven Vorlaufsignalpfades 10 steht das selektive Vorlauf-Regelsignal RS_{SV} zur Verfügung, während am Ausgang des selektiven Rücklaufsignalzweiges 16 das selektive Rücklauf-Regelsignal RS_{SR} zur Verfügung steht.

Das selektive Vorlauf-Regelsignal RS_{SV} entspricht unmittelbar dem dem Regler 8 zugeführten Vorlauf-Regelsignal RS_{V}. Das selektive Rücklauf-Regelsignal RS_{SR} hingegen wird bei dem in Fig. 1 dargestellten bevorzugten Ausführungsbeispiel einem Signalkombinierer 22 zugeführt, der das selektive Rücklauf-Regelsignal RS_{SR} mit einem breitbandigen, nicht selektiven Rücklauf-Regelsignal RS_{BR} zu dem effektiven Rücklauf-Regelsignal RS_{R} kombiniert, welches dem Regler 8 zugeführt wird.

Zur Erzeugung eines breitbandigen, nicht selektiven Vorlauf-Regelsignals RS_{BV} dient ein breitbandiger Vorlaufsignalzweig 23, welcher im dargestellten Ausführungsbeispiel durch einen dritten Gleichrichter 25 und einen dritten Verstärker 26 gebildet ist, wobei dem dritten Gleichrichter 25 das Vorlaufsignal U_{V} ohne vorgeschaltete Selektionsmittel zugeführt wird. Entsprechend dient ein breitbandiger Rücklaufsignalzweig 24 zur Erzeugung eines breitbandigen, nicht selektiven Rücklauf-Regelsignals RS_{HR}. Der breitbandige Rücklaufsignalzweig 24 besteht im dargestellten Ausführungsbeispiel aus einem vierten Gleichrichter 27 und einem vierten Verstärker 28, wobei auch hier das Rücklaufsignal U_{R} dem vierten Gleichrichter 27 ohne vorgeschaltete Selektionsmittel unmittelbar zugeführt wird.

In dem Signalkombinierer 22 werden das selektive Rücklauf-Regelsignal RS_{SR} und das breitbandige Rücklauf-Regelsignal RS_{BR} nichtlinear miteinander in der Weise kombiniert, daß unterhalb eines vorgegebenen Schwellwerts des breitbandigen Rücklauf-Regelsignals RS_{HR} in dem effektiven Rücklauf-Regelsignal RS_{R} das selektive Rücklauf-Regelsignal RS_{SR} dominiert, während das selektive Rücklauf-Regelsignal RS_{SR} oberhalb dieses Schwellwerts derart übersteuert wird, daß oberhalb dieses Schwellwerts in dem resultierenden Rücklauf-Regelsignal RS_{R} das breitbandige Rücklauf-Regelsignal RS_{BR} dominiert.

Auf diese Weise wird folgendes erreicht: Sind nur geringe Einflüsse außerhalb des von dem selektiven Rücklaufsignalzweig 16 selektierten Betriebskanals beispielsweise durch benachbarte Sender vorhanden, so beeinflussen die benachbarten Sender das Rücklauf-Regelsignal RS_{R} nicht. Zwar wird das Signal benachbarter Sender von dem breitbandigen Rücklaufsignalzweig 24 erfaßt. Ist das Signal der benachbarten Sender jedoch relativ schwach und unterhalb eines kritischen Schwellwerts, so hat das breitbandige Rücklauf-Regelsignal RS_{HR} keinen oder allenfalls einen vernachlässigbar geringen Einfluß auf das effektive Rücklauf-Regelsignal RS_{R}.

Wird die Einkopplung benachbarter Sender jedoch so stark, daß eine Gefährdung der Leistungsendstufe 4 aufgrund der von den Fremdsendern eingekoppelten Leistung zu befürchten ist, so übersteuert das breitbandige Rücklauf-Regelsignal RS_{BR} aufgrund der Auslegung des nichtlinearen Signalkombinierers 22 das selektive Rücklauf-Regelsignal RS_{SR}, so daß das effektive Rücklauf-Regelsignal RS_{R} im wesentlichen durch das breitbandige Rücklauf-Regelsignal RS_{BR} und somit durch die eingekoppelte Leistung der Nachbarsender bestimmt ist. Da das Vorlauf-Regelsignal RS_{V} durch die Einkopplung der Fremdsender nicht beeinflußt wird, führt die aufgrund der Fremdsender hervorgerufene Veränderung des Verhältnisses zwischen RS_{V} und RS_{R} dazu, daß der Regler 8 die Leistung der Leistungsendstufe 4 zurückregelt. Dadurch wird sichergestellt, daß die Summe der in der Leistungsendstufe hervorgerufene Verlustleistung und der von den Fremdsendern eingekoppelten Leistungsanteile nicht zu einer thermischen Zerstörung der Leistungsendstufe 4 führen kann.

Bei der in Fig. 1 dargestellten bevorzugten Weiterbildung der Erfindung ist ferner eine Notabschaltung vorgesehen. Dazu wird in einem Komparator 29 das selektive Vorlauf-Regelsignal RS_{SV} mit dem breitbandigen Vorlauf-Regeisignal RS_{BV} verglichen. Arbeitet der selektive Vorlaufsignalzweig 10 ordnungsgemäß, so muß das Verhältnis von RS_{BV} zu RS_{SV} unabhängig von der in der Leistungsendstufe 4 erzeugten Sendeleistung und unabhängig von der Betriebsfrequenz in etwa konstant sein, da die Selektion des selektiven Vorlaufsignalzweigs 10 ständig der Betriebsfrequenz nachgeführt wird. Erhöht sich jedoch das breitbandige VorlaufRegeisignal RS_{BV} gegenüber dem selektiven Vorlauf-Regelsignal RS_{SV} unverhältnismäßig, was durch den Komparator 29 festgestellt wird, so läßt dies darauf schießen, daß eine Komponente des selektiven Vorlaufsignalzweiges 10 nicht ordnungsgemäß arbeitet. Beispielsweise kann der Mischer 12 nicht mehr auf die Zwischenfrequenz umsetzen, wenn der noch im Detail zu beschreibende Synthesizer 33 ausfällt.

Wird diese Betriebsstörung durch den Komparator 29 erkannt, so übermittelt dieser ein Notabschaltsignal NA vorzugsweise über ein Verzögerungselement 30 an eine Steuereinheit 31. Diese erzeugt ein Steuersignal (TX Inhibit), welches über eine Steuerleitung 32 an den Leistungsverstärker 3 geführt ist und zur Abschaltung der Leistungsendstufe 4 führt. Vorzugsweise wird das Notabschaltsignal NA erst dann der Steuereinheit 31 zugeführt, wenn es in dem Verzögerungselement 30 für eine gewisse Mindestzeit anliegt. Dies dient zur Vermeidung von Fehlauslösungen der Notabschaltung aufgrund von Regelverzögerungen oder aufgrund einer Einstellverzögerung des Synthesizers 33.

Der Vollständigkeit halber wird noch auf den Aufbau des in Fig. 1 dargestellten Synthesizers 33 eingegangen, der im dargestellten Ausführungsbeispiel nach dem PLL(Phase Locked Loop)-Prinzip arbeitet. Die Frequenzerzeugung des Synthesizers erfolgt in einem Oszillator 34, beispielsweise einem Quarz-Oszillator, dessen Ausgang über eine DDS(Direkte Digitale Synthese)-Schaltung 35 und über einen Bandpaß 36 einem Phasen-Komparator 37 zugeführt wird. Dieser ist in üblicher Weise über ein Schleifen-Filter 38 mit einem gesteuerten Oszillator 39, üblicherweise einem spannungsgesteuerten Oszillator, verbunden, dessen Ausgang eines der beiden Vergleichssignale für den Phasen-Komparator 37 zur Verfügung stellt. Das Ausgangssignal des gesteuerten Oszillators 39 ist über entsprechende Verstärker 40 und 41, die auch der Entkopplung dienen, mit den Mischern 12 und 18 verbunden.

Vorteilhaft kann das Signal des Synthesizers 33 auch gleichzeitig für die Signalaufbereitung in der dem Leistungsverstärker 3 vorgeschalteten Signalaufbereitungseinrichtung 2 verwendet werden. Dies hat einerseits den Vorteil, daß nur ein Synthesizer 33 erforderlich ist und ein Frequenzwechsel synchron in der Signalaufbereitungseinrichtung 2 als auch in den selektiven Regelzweigen 10 und 16 berücksichtigt wird. Die Verwendung des Ausgangssignals des ohnehin für die Signalaufbereitung erforderlichen Synthesizers 33 für das Referenzsignal der Mischer 12 und 18 hat außerdem den Vorteil, daß der beim Stand der Technik erforderliche Signalabgriff vor der Leistungsendstufe 3 entfallen kann.

Der Vollständigkeit halber sei darauf hingewiesen, daß die Steuereinheit 31 natürlich noch weitere Steuerfunktionen übernehmen kann. Beispielsweise kann durch ein Eingangssignal "TX Inhibit", welches von den Oberflächenwellen-Filtern 13 und 19 kommt, eine Notabschaltung auch dann hervorgerufen werden, wenn eines der beiden Oberflächenwellen-Filter 13 oder 19 ausfällt. Die Steuereinheit 31 kann ferner die Steuerung des Phasen-Komparators 37 und der DDS-Schältung 35 übernehmen.

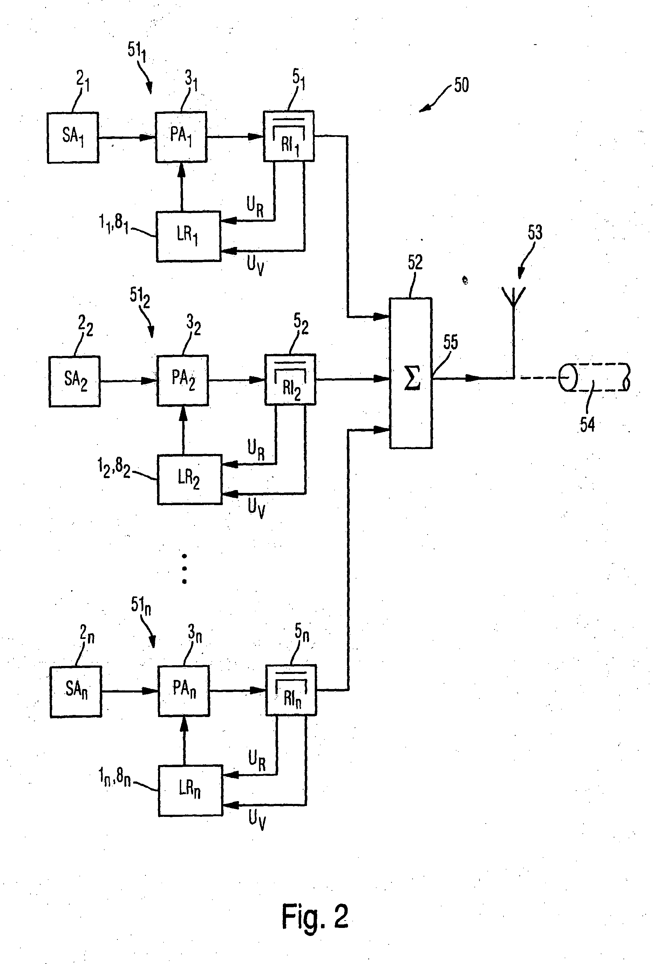

Fig. 2 zeigt eine weitere Anwendungsmöglichkeit der erfindungsgemäßen Leistungsregelvorrichtung 1 bei einer Breitbandanlage 50. Bei dieser Breitbandanlage sind mehrere Sendeeinrichtungen 51₁, 51₂, ..., 51ₙ an einem Signalkombinierer 52 zusammengeschaltet, wobei das kombinierte Signal über einen gemeinsamen Ausgang 55 einer gemeinsamen Antenne 53 zugeführt wird. Anstatt der Antenne 53 kann auch eine Einspeisung in ein Breitband-Kabel 54 vorhanden sein, was in Fig. 2 gestrichelt dargestellt ist. Jede Sendeeinrichtung 51₁, 51₂, ..., 51ₙ besteht wie bei dem in Fig. 1 dargestellten Ausführungsbeispiel aus einer Signalaufbereitungseinrichtung 2₁, 2₂, ... , 2ₙ, einem Leistungsverstärker 3₁, 3₂, ... , 3ₙ, einem Richtkoppler 5₁, 5₂, ..., 5ₙ und einer Leistungsregelvorrichtung 1₁, 1₂, ..., 1ₙ mit einem entsprechenden Regler 8₁, 8₂, ..., 8ₙ. Diese Komponenten arbeiten wie anhand Fig. 1 vorstehend erläutert.

Bei der Breitbandanlage 50 besteht in besonderem Maße die Problematik, daß die jeweils anderen Sendeeinrichtungen 51₂, ..., 51ₙ in eine bestimmte Sendeeinrichtung 51₁ einkoppeln und zu einer Zerstörung der Leistungsendstufe des jeweiligen Leistungsverstärkers 3₁ führen können. Zwar sorgt der Signalkombinierer 52 für eine gewisse Entkopplung der einzelnen Sendeeinrichtungen 51₁, 51₂, ..., 51ₙ, jedoch ist das Rücklaufsignal U_{R} von den benachbarten Sendeeinrichtungen nicht unbeeinflußt. Wird der Signalkombinierer 52 beispielsweise durch Überhitzung beschädigt, so kann eine unzulässig hohe Einkopplung der benachbarten Sendeeinrichtungen nicht ausgeschlossen werden, so daß sich bei diesem Anwendungsfall die Kombination des selektiven Rücklaufs mit dem breitbandigen Rücklauf, wie in Fig. 1 dargestellt, besonders bewährt.

Die Erfindung ist nicht auf das dargestellte Ausführungsbeispiel beschränkt und kann in unterschiedlicher Weise realisiert werden. Insbesondere sind der breitbandige Rücklaufsignalzweig und dessen Kombination mit dem selektiven Rücklaufsignalzweig, der breitbandige Vorlaufsignalzweig und die Notabschaltung nur optionale Weiterbildungen der Erfindung, die erfindungsgemäß nicht zwingend notwendig sind. Gleiches gilt für die Speisung der Mischer 12 und 18 durch den Synthesizer 33. Alternativ könnte, wie beim Stand der Technik, auch ein Signalabgriff vor dem Leistungsverstärker 3 zur Erzeugung des Referenzsignals für die Mischer 12 und 18 in Betracht kommen.

## Patentansprüche

1. Leistungsregelvorrichtung (1) für eine Leistungsendstufe (4) in einer Sendeeinrichtung, die so ausgebildet ist, dass über einen Richtkoppler (5) ein einer auf einer Wellenzuleitung (7) vorlaufenden Welle entsprechendes Vorlaufsignal (Uv) und ein einer auf der Wellenzuleitung (7) rücklaufenden Welle entsprechendes Rücklaufsignal (U_{R}) gewonnen werden und nach einer schmalbandigen Selektion einem Regler (8) zur Regelung der Leistung der Leistungsendstufe (4) zugeführt werden,
**dadurch gekennzeichnet,**
**dass** die Leistungsregelvorrichtung (1) so ausgebildet ist, dass die schmalbandige Selektion nicht im Basisband, sondern auf einer konstanten Zwischenfrequenzebene, die oberhalb der höchsten Betriebsfrequenz der Sendeeinrichtung und somit oberhalb des Basisbands liegt, durchgeführt ist, wobei die schmalbandige Selektion schmal bezüglich der gesamten Nutzbandbreite der Leistungsendstufe (4) ist und
**dass** das Vorlaufsignal (U_{V}) einem selektiven Vorlaufsignalzweig (10) mit einem ersten Mischer (12) und einem ersten schmalbandigen Zwischenfrequenzfilter (13) zur Gewinnung eines selektiven Vorlauf-Regelsignals (RS_{SV}) zugeführt ist.

2. Leistungsregelvorrichtung nach Anspruch 1,
**dadurch gekennzeichnet,**
**dass** das Rücklaufsignal (U_{R}) einem selektiven Rücklaufsignalzweig (16) mit einem zweiten Mischer (18) und einem zweiten schmalbandigen Zwischenfrequenzfilter (19) zur Gewinnung eines selektiven Rücklauf-Regelsignals (RS_{SR}) zugeführt ist.

3. Leistungsregelvorrichtung nach Anspruch 1 oder 2,
**dadurch gekennzeichnet,**
**dass** das erste schmalbandige Zwischenfrequenzfilter (13) und das zweite schmalbandige Zwischenfrequenzfilter (19) ein Oberflächenwellen-Filter sind.

4. Leistungsregelvorrichtung nach einem der Ansprüche 1 bis 3,
**dadurch gekennzeichnet,**
**dass** dem ersten Mischer (12) und dem zweiten Mischer (18) das Signal eines die Betriebsfrequenz einer der Leistungsendstufe (4) vorgeschalteten Signalaufbereitungseinrichtung (2) festlegenden Frequenzsynthesizers (33) zugeführt ist.

5. Leistungsregelvorrichtung nach Anspruch 4,
**dadurch gekennzeichnet,**
**dass** der Frequenzsynthesizer (33) eine PLL (Phase Locked Loop) - Schleife (37-39) beinhaltet.

6. Leistungsregelvorrichtung nach einem der Ansprüche 1 bis 5,
**dadurch gekennzeichnet,**
**dass** dem ersten Mischer (12) ein erster Tiefpaß (11) und/oder dem zweiten Mischer (18) ein zweiter Tiefpaß (17) mittelbar oder unmittelbar vorgeschaltet ist, dessen Grenzfrequenz der höchsten Betriebsfrequenz der Leistungsendstufe (4) entspricht.

7. Leistungsregelvorrichtung nach einem der Ansprüche 1 bis 6,
**dadurch gekennzeichnet,**
**dass** dem ersten Zwischenfrequenzfilter (13) ein erster Gleichrichter (15) und/oder dem zweiten Zwischenfreuenzfilter (19) ein zweiter Gleichrichter (21) mittelbar oder unmittelbar nachgeschaltet ist.

8. Leistungsregelvorrichtung nach einem der Ansprüche 1 bis 7,
**dadurch gekennzeichnet,**
**dass** die Leistungsregelvorrichtung (1) so ausgebildet ist, dass das Vorlaufsignal (U_{V}) einem breitbandigen Vorlaufsignalzweig (23) zur Gewinnung eines nicht selektiven, breitbandigen Vorlauf-Regelsignals (RS_{BV}) zugeführt ist, das mit dem selektive Vorlauf-Regelsignal (RS_{SV}) einem Komparator (29) zugeführt ist, der bei Überschreiten eines vorgegebenen Verhältnisses zwischen breitbandigem Vorlauf-Regelsignal (RS_{BV}) und selektivem Vorlauf-Regelsignal (RS_{SV}) ein Notabschaltsignal (NA) erzeugt, das zum Abschalten der Leistungsendstufe (4) führt.

9. Leistungsregelvorrichtung nach Anspruch 8,
**dadurch gekennzeichnet,**
**dass** der breitbandige Vorlaufsignalzweig (23) einen dritten Gleichrichter (25) enthält.

10. Leistungsregelvorrichtung nach Anspruch 8 oder 9,
**dadurch gekennzeichnet,**
**dass** das Notabschaltsignal (NA) über ein Verzögungselement (30) einer Steuereinheit (31) zum Ansteuern der Leistungsendstufe (4) zugeführt ist.

11. Leistungsregelvorrichtung nach Anspruch 2,
**dadurch gekennzeichnet,**
**dass** die Leistungsregelvorrichtung (1) so ausgebildet ist, dass das Rücklaufsignal (U_{R}) einem breitbandigen Rücklaufsignalzweig (24) zur Gewinnung eines nicht selektiven, breitbandigen Rücklauf-Regelsignals (RS_{BR}) zugeführt ist, das mit dem selektiven Rücklauf-Regelsignal (RS_{SR}) in einem Signalkombinierer (22) zu einem effektiven Rücklauf-Regelsignal (RS_{R}) derart nichtlinear miteinander kombiniert ist, dass unterhalb eines vorgegebenen Schwellwerts des breitbandigen Rücklauf-Regelsignals (RS_{BR}) das selektive Rücklauf-Regelsignal (RS_{SR}) in dem effektiven Rücklauf-Regelsignal (RS_{R}) dominiert, während das selektive Rücklauf-Regelsignal (RS_{SR}) oberhalb dieses Schwellwerts derart übersteuert ist, dass das breitbandige Rücklauf-Regelsignal (RSBR) in dem effektiven Rücklauf-Regelsignal (RS_{R}) dominiert.

12. Leistungsregelvorrichtung nach Anspruch 11,
**dadurch gekennzeichnet,**
**dass** der breitbandige Rücklaufsignalzweig (24) einen vierten Gleichrichter (27) enthält.

13. Leistungsregelvorrichtung nach Anspruch 11 oder 12,
**dadurch gekennzeichnet,**
**dass** die Leistungsregelvorrichtung (1) so ausgebildet ist, dass das in dem Signalkombinierer (22) erzeugte, übersteuerte effektive Rücklauf-Regelsignal (RS_{R}) und das selektive Vorlauf-Regelsignal (RS_{SV}) dem Regler (8) zugeführt sind, der die Leistungsendstufe (4) mit zunehmendem Verhältnis von übersteuertem, effektivem Rücklauf-Regelsignal (RS_{R}) zu selektivem Vorlauf-Regelsignal (RS_{SV}) zunehmend rückregelt.

14. Breitbandanlage mit mehreren Sendeeinrichtungen (51₁, 51₂, ..., 51ₙ), deren Ausgänge über einen Signalkombinierer (52) zu einem gemeinsamen Ausgang (55) zusammengeschaltet sind, wobei jede Sendeeinrichtung (51₁, 5₁₂,..., 51ₙ) jeweils einen Leistungsverstärker (3₁, 3₂,..., 3ₙ) und für jeden Leistungsverstärker (3₁, 3₂,..., 3ₙ) jeweils eine Leistungsregelanordnung (1₁, 1₂,..., 1ₙ) nach einem der Patentansprüche 1 bis 13 aufweist.

## Claims

1. Power control device (1) for a power output stage (4) in a transmitting device which is embodied so that a forward signal (U_{V}) corresponding to a forward wave on a wave guide (7) and a return signal (U_{R}) corresponding to a return wave on the wave guide (7) are obtained by means of a directional coupler (5) and after a narrow band selection are fed to a controller (8) for controlling the power of the power output stage (4),
**characterised in that**
the power control device (1) is embodied so that the narrow band selection is carried out not in the base band but on a constant intermediate frequency level which lies above the highest operating frequency of the transmitting device and thus above the base band, wherein the narrow band selection is narrow with respect to the entire useful bandwidth of the power output stage (4), and
**in that** the forward signal (U_{V}) is fed to a selective forward signal branch (10) with a first mixer (12) and a first narrow band intermediate frequency filter (13) to obtain a selective forward control signal (RS_{SV}).

2. Power control device according to claim 1,
**characterised in that**
the return signal (U_{R}) is fed to a selective return signal branch (16) with a second mixer (18) and a second narrow band intermediate frequency filter (19) to obtain a selective return control signal (RS_{SR}).

3. Power control device according to claim 1 or 2,
**characterised in that**
the first narrow band intermediate frequency filter (13) and the second narrow band intermediate frequency filter (19) are a surface wave filter.

4. Power control device according to one of claims 1 to 3,
**characterised in that**
the signal of a frequency synthesizer (33) fixing the operating frequency of a signal processing device (2) connected before the power output stage (4) is fed to the first mixer (12) and the second mixer (18).

5. Power control device according to claim 4,
**characterised in that**
the frequency synthesizer (33) incorporates a PLL loop (Phase Locked Loop) (37-39).

6. Power control device according to one of claims 1 to 5,
**characterised in that**
a first low pass filter (11) the limit frequency of which corresponds to the highest operating frequency of the power output stage (4) is connected directly or indirectly before the first mixer (12) and/or a second low pass filter (17) the limit frequency of which corresponds to the highest operating frequency of the power output stage (4) is connected directly or indirectly before the second mixer (18).

7. Power control device according to one of claims 1 to 6,
**characterised in that**
a first rectifier (15) is connected directly or indirectly after the first intermediate frequency filter (13) and/or a second rectifier (21) is connected directly or indirectly after the second intermediate frequency filter (19).

8. Power control device according to one of claims 1 to 7,
**characterised in that**
the power control device (1) is embodied so that the forward signal (U_{V}) is fed to a broadband forward signal branch (23) to obtain a non-selective broadband forward control signal (RS_{BV}) which is fed with the selective forward control signal (RS_{SV}) to a comparator (29) which if a predetermined ratio between the broadband forward control signal (RS_{BV}) and the selective forward control signal (RS_{SV}) is exceeded generates an emergency switch-off signal (NA) which leads to the power output stage (4) being switched off.

9. Power control device according to claim 8,
**characterised in that**
the broadband forward signal branch (23) comprises a third rectifier (25).

10. Power control device according to claim 8 or 9,
**characterised in that**
the emergency switch-off signal (NA) is fed via a delay element (30) to a control unit (31) to control the power output stage (4).

11. Power control device according to claim 2,
**characterised in that**
the power control device (1) is embodied so that the return signal (U_{R}) is fed to a broadband return signal branch (24) to obtain a non-selective broadband return control signal (RS_{BR}) which is combined in non-linear fashion with the selective return control signal (RS_{SR}) in a signal combiner (22) to form an effective return control signal (RS_{R}) in such a way that below a predetermined threshold value of the broadband return control signal (RS_{BR}) the selective return control signal (RS_{SR}) in the effective return control signal (RS_{R}) dominates, whereas above this threshold value the selective return control signal (RS_{SR}) is overridden in such a way that the broadband return control signal (RS_{BR}) in the effective return control signal (RS_{R}) dominates.

12. Power control device according to claim 11,
**characterised in that**
the broadband return signal branch (24) comprises a fourth rectifier (27).

13. Power control device according to claim 11 or 12,
**characterised in that**
the power control device (1) is embodied so that the overridden effective return control signal (RS_{R}) produced in the signal combiner (22) and the selective forward control signal (RS_{SV}) are fed to the controller (8) which increasingly turns down the power output stage (4) as the ratio of the overridden effective return control signal (RS_{R}) to the selective forward control signal (RS_{SV}) increases.

14. Broadband installation with a plurality of transmitting devices (51₁, 51₂, ..., 51ₙ) the outputs of which are switched together by means of a signal combiner (52) to form a common output (55), wherein each transmitting device (51₁, 51₂, ..., 51ₙ) in each case exhibits a power amplifier (3₁, 3₂, ..., 3ₙ) and for each power amplifier (3₁, 3₂, ..., 3ₙ) in each case a power control arrangement (1₁, 1₂, ..., 1ₙ) according to one of patent claims 1 to 13.

## Revendications

1. Dispositif de régulation de puissance (1) pour un étage de sortie de puissance (4) dans un dispositif d'émission, qui est réalisé de sorte qu'un signal d'avance (U_{V}) correspondant à une onde se déplaçant sur une alimentation en ondes (7) et un signal de retour (U_{R}) correspondant à une onde retournant parallèlement à l'alimentation en ondes (7) sont obtenus par l'intermédiaire d'un coupleur directif (5) et sont délivrés après une sélection de bande étroite à un régulateur (8) en vue de la régulation de la puissance de l'étage de sortie de puissance (4),
**caractérisé en ce que**
le dispositif de régulation de puissance (1) est réalisé de sorte que la sélection de bande étroite est réalisée non pas dans la bande de base, mais sur un domaine de fréquences intermédiaires constant, qui se trouve au-dessus de la fréquence de fonctionnement la plus élevée du dispositif d'émission et ainsi au-dessus de la bande de base, dans lequel la sélection de bande étroite est étroite par rapport à l'ensemble de la largeur de bande utile de l'étage de sortie de puissance (4) et
**en ce que** le signal d'avance (U_{V}) est délivré à un chemin du signal d'avance sélective (10) comportant un premier mélangeur (12) et un premier filtre de fréquences intermédiaires à bande étroite (13) pour obtenir un signal de régulation d'avance sélectif (RS_{SV}).

2. Dispositif de régulation de puissance selon la revendication 1, **caractérisé en ce que**
le signal de retour (U_{R}) est délivré à un chemin du signal de retour sélectif (16) comportant un second mélangeur (18) et un second filtre de fréquences intermédiaires à bande étroite (19) pour obtenir un signal de régulation de retour sélectif (RS_{SR}).

3. Dispositif de régulation de puissance selon la revendication 1 ou 2, **caractérisé en ce que**
le premier filtre de fréquences intermédiaires à bande étroite (13) et le second filtre de fréquences intermédiaires à bande étroite (19) sont des filtres à ondes superficielles.

4. Dispositif de régulation de puissance selon l'une des revendications 1 à 3, **caractérisé en ce que**
le signal d'un synthétiseur de fréquences (33) déterminant la fréquence de fonctionnement d'un dispositif de traitement de signal (2) monté en amont de l'étage de sortie de puissance (4) est délivré au premier mélangeur (12) et au second mélangeur (18).

5. Dispositif de régulation de puissance selon la revendication 4, **caractérisé en ce que**
le synthétiseur de fréquences (33) comporte une boucle PLL (Phase Locked Loop) (37-39).

6. Dispositif de régulation de puissance selon l'une des revendications 1 à 5, **caractérisé en ce que**
un premier filtre passe-bas (11) est monté en amont directement ou indirectement du premier mélangeur (12) et/ou un second filtre passe-bas (17) est monté en amont directement ou indirectement du second mélangeur (18), dont la fréquence limite correspond à la fréquence de fonctionnement la plus élevée de l'étage de sortie de puissance (4).

7. Dispositif de régulation de puissance selon l'une des revendications 1 à 6, **caractérisé en ce que**
un premier redresseur (15) est monté en aval directement ou indirectement du premier filtre de fréquences intermédiaires (13) et/ou un second redresseur (21) est monté en aval directement ou indirectement du second filtre de fréquences intermédiaires (19).

8. Dispositif de régulation de puissance selon l'une des revendications 1 à 7, **caractérisé en ce que**
le dispositif de régulation de puissance (1) est réalisé de sorte que le signal d'avance (U_{V}) est délivré à un chemin du signal d'avance à large bande (23) pour obtenir un signal de régulation d'avance à large bande non sélectif (RS_{BV}), qui est délivré avec le signal de régulation d'avance sélectif (RS_{SV}) à un comparateur (29), qui génère un signal de coupure d'urgence (NA) dans le cas du dépassement d'un rapport prédéterminé entre le signal de régulation d'avance à large bande (RS_{BV}) et le signal de régulation d'avance sélectif (RS_{SV}) qui conduit à la coupure de l'étage de sortie de puissance (4).

9. Dispositif de régulation de puissance selon la revendication 8, **caractérisé en ce que**
le chemin du signal d'avance à large bande (23) comporte un troisième redresseur (25).

10. Dispositif de régulation de puissance selon la revendication 8 ou 9, **caractérisé en ce que**
le signal de coupure d'urgence (NA) est délivré à une unité de commande (31) par l'intermédiaire d'un élément de retard (30) pour commander l'étage de sortie de puissance (4).

11. Dispositif de régulation de puissance selon la revendication 2, **caractérisé en ce que**
le dispositif de régulation de puissance (1) est réalisé de sorte que le signal de retour (U_{R}) est délivré à un chemin du signal de retour à large bande (24) pour obtenir un signal de régulation de retour à large bande non sélectif (RS_{BR}), qui est combiné de façon non linéaire avec le signal de régulation de retour sélectif (RS_{SR}) dans un combineur de signal (22) en un signal de régulation de retour effectif (RS_{R}) de sorte que le signal de régulation de retour sélectif (RS_{SR}) domine dans le signal de régulation de retour effectif (RS_{R}) en deçà d'une valeur de seuil prédéterminée du signal de régulation de retour à large bande (RS_{BR}), tandis que le signal de régulation de retour sélectif (RS_{SR}) est surmodulé au-dessus de cette valeur de seuil de sorte que le signal de régulation de retour à large bande (RSBR) domine dans le signal de régulation de retour effectif (RS_{R}).

12. Dispositif de régulation de puissance selon la revendication 11, **caractérisé en ce que**
le chemin du signal de retour à large bande (24) comporte un quatrième redresseur (27).

13. Dispositif de régulation de puissance selon la revendication 11 ou 12, **caractérisé en ce que**
le dispositif de régulation de puissance (1) est réalisé de sorte que le signal de régulation de retour (RS_{R}) effectif surmodulé généré dans le combineur de signal (22) et le signal de régulation d'avance sélectif (RS_{SV}) sont délivrés au régulateur (8), qui règle en retour l'étage de sortie de puissance (4) de manière croissante au fur et à mesure que le rapport du signal de régulation de retour (RS_{R}) effectif surmodulé par rapport au signal de régulation d'avance sélectif (RS_{SV}) augmente.

14. Dispositif à large bande comportant plusieurs dispositifs d'émission (51₁, 51₂,..., 51ₙ), dont les sorties sont conjointement commutées à une sortie commune (55) par l'intermédiaire d'un combineur de signal (52), dans lequel chaque dispositif d'émission (51₁, 51₂,..., 51ₙ) présente respectivement un amplificateur de puissance (3₁, 3₂,..., 3ₙ) et pour chaque amplificateur de puissance (3₁, 3₂,..., 3ₙ) respectivement un dispositif de régulation de puissance (1₁, 1₂,..., 1ₙ) selon l'une des revendications 1 à 13.
